# EUROPEAN PATENT SPECIFICATION

(11) **EP 4 105 066 B1**
(45) Date of publication and mention of the grant of the patent: **11.06.2025**
(21) Application number: 22170574.2
(22) Date of filing: 28.04.2022
(51) Int. Cl.: B60L 53/36, B60L 53/39, B60L 53/126, H02J 7/02, B60L 53/65, B60L 53/66, H02J 50/12, H02J 50/40, H02J 50/90

(54) **CONTACTLESS POWER SUPPLY SYSTEM, POSITION ESTIMATION METHOD, MOBILE BODY, AND POWER SUPPLY DEVICE**
KONTAKTLOSES STROMVERSORGUNGSSYSTEM, POSITIONSBESTIMMUNGSVERFAHREN, MOBILER KÖRPER UND STROMVERSORGUNGSVORRICHTUNG
SYSTÈME D'ALIMENTATION ÉLECTRIQUE SANS CONTACT, PROCÉDÉ D'ESTIMATION DE POSITION, CORPS MOBILE, ET DISPOSITIF D'ALIMENTATION ÉLECTRIQUE

(30) Priority: 17.06.2021 JP 2021101215
(43) Date of publication of application: 21.12.2022
(73) Proprietor: TOYOTA JIDOSHA KABUSHIKI KAISHA, Toyota-shi, Aichi-ken, 471-8571 (JP)
(72) Inventor: OKAZAKI, Shuntaro, Toyota-shi, 471-8571 (JP); MATSUDA, Kazuhisa, Toyota-shi, 471-8571 (JP); YOKOYAMA, Daiki, Toyota-shi, 471-8571 (JP)
(74) Representative: D Young & Co LLP

(56) References cited:
- WO-A2-2014/174361
- US-A1- 2014 054 970
- US-A1- 2014 138 199
- US-A1- 2016 318 413
- US-A1- 2019 009 681
- US-B2- 10 137 794

## Description

### BACKGROUND OF THE INVENTION

### 1. Field of the Invention

The present invention relates to a contactless power supply system, a position estimation method, a mobile body, and a power supply device.

### 2. Description of Related Art

Hitherto, there is known a technology for contactless transmission of electric power between a ground-side device provided on the ground and a mobile body such as a vehicle using a transmission method such as magnetic field coupling (electromagnetic induction), electric field coupling, magnetic field resonance coupling (magnetic field resonance), or electric field resonance coupling (electric field resonance). Particularly in contactless electric power transmission of magnetic field resonance coupling using a transmission-side resonance circuit and a reception-side resonance circuit having the same resonance frequency, large electric power can be transmitted via an alternating current magnetic field generated in the transmission-side resonance circuit even if the mobile body and the ground-side device are located away from each other.

However, constant generation of the alternating current magnetic field for electric power transmission between the ground-side device and the mobile body leads to a waste of electric power. There is also concern about influence of the alternating current magnetic field on electronic devices or the like. Therefore, it is desirable to generate the alternating current magnetic field for electric power transmission at an appropriate timing when the mobile body passes over the ground-side device.

In this regard, Japanese Unexamined Patent Application Publication No. 2018-157686 (JP 2018-157686 A) describes that, when a power supply request is wirelessly transmitted from a vehicle, a power supply device embedded in a road contactlessly transmits electric power to the vehicle while the vehicle passes over the road.

US 2016/318413 A1 discusses wireless charging for vehicle batteries.

WO 2014/174361 A2 discusses a power receiving device, a parking assist system, and a power transfer system.

US 10 137 794 B2 discusses a method and apparatus for a wireless charging system.

US 2019/009681 A1 discusses a method and apparatus for positioning a motor vehicle above a ground plate. US 2014/054970 A1 discloses a position estimation method to be applied to a contactless power supply system configured to perform contactless electric power transmission of magnetic field resonance coupling between a ground-side device and a mobile body, the contactless power supply system including an alternating current magnetic field generation circuit provided in the ground-side device, a magnetic field detector provided in the mobile body, a transmission-side resonance circuit provided in the mobile body wherein a plurality of the magnetic field detectors is provided along a direction perpendicular to a travelling direction of the mobile body, and a reception-side resonance circuit provided in the ground side device.

### SUMMARY OF THE INVENTION

The present invention is defined by the appended independent claims.

In a case where the approach of the vehicle to the ground-side device is detected by wireless communication, however, there is a possibility that the alternating current magnetic field cannot be generated at the appropriate timing due to hindrance to the wireless communication by an obstacle or the like. When the transmission-side resonance circuit and the reception-side resonance circuit are misaligned while the mobile body such as a vehicle is passing over the ground-side device, the efficiency of electric power transmission decreases.

The present invention provides a contactless power supply system, a position estimation method, a mobile body, and a power supply device in which a relative positional relationship between a transmission-side resonance circuit and a reception-side resonance circuit is accurately detected during contactless electric power transmission of magnetic field resonance coupling between the mobile body and a ground-side device.

According to the contactless power supply system, the position estimation method, the mobile body, and the power supply device of the present invention, the relative positional relationship between the transmission-side resonance circuit and the reception-side resonance circuit can accurately be detected during the contactless electric power transmission of magnetic field resonance coupling between the mobile body and the ground-side device.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a diagram schematically illustrating a configuration of a contactless power supply system according to a first example of the present invention;
FIG. 2 is a schematic configuration diagram of a controller of a ground-side device that is an example of a power supply device according to the first example of the present invention;
FIG. 3 is a schematic configuration diagram of an electronic control unit (ECU) of a vehicle that performs contactless electric power transmission of magnetic field resonance coupling (magnetic field resonance) with the ground-side device;
FIG. 4 is a functional block diagram of a processor of the controller;
FIG. 5 is a flowchart illustrating a control routine of a power supply process according to the first example of the present invention;
FIG. 6 is a diagram schematically illustrating a part of a configuration of a contactless power supply system according to a second embodiment of the present invention;
FIG. 7 is a diagram illustrating an example of arrangement of magnetic field detectors according to a third embodiment of the present invention;
FIG. 8 is a flowchart illustrating a control routine of a power supply process according to the third embodiment of the present invention;
FIG. 9 is a diagram illustrating an example of arrangement of magnetic field detectors and transmission-side resonance circuits according to a fourth embodiment of the present invention;
FIG. 10 is a flowchart illustrating a control routine of a power supply process according to the fourth embodiment of the present invention;
FIG. 11 is a diagram schematically illustrating a configuration of a contactless power supply system according to an embodiment of the present invention;
FIG. 12 is a functional block diagram of a processor of an ECU constituting the contactless power supply system according to the embodiment of figure 11; and
FIG. 13 is a flowchart illustrating a control routine of a power supply process according to the embodiment of the present invention.

### DETAILED DESCRIPTION OF EMBODIMENTS

Embodiments of the present invention will be described below in detail with reference to the drawings. In the following description, like constituent elements are denoted by like reference numerals.

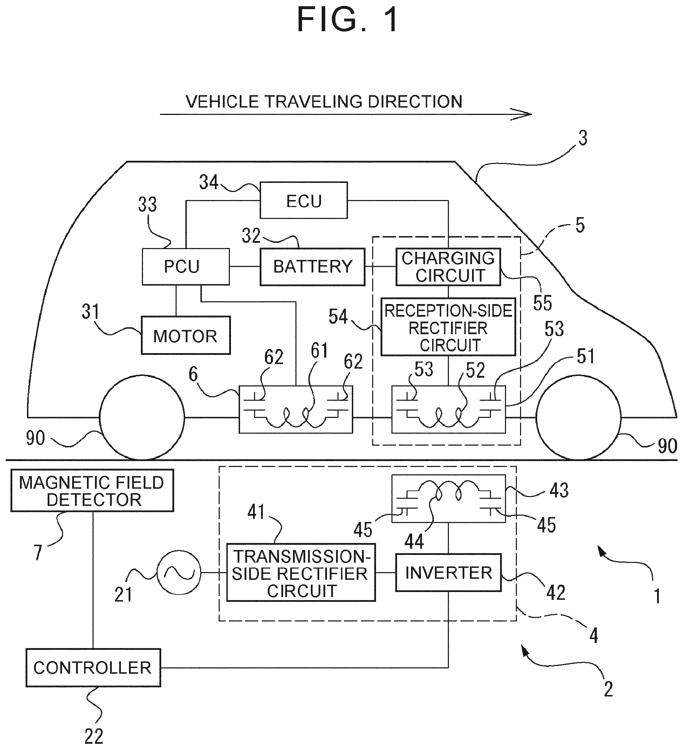

A first example of the present invention will be described below with reference to FIGS. 1 to 5.

FIG. 1 is a diagram schematically illustrating a configuration of a contactless power supply system 1 according to the first embodiment of the present invention. The contactless power supply system 1 performs contactless electric power transmission of magnetic field resonance coupling (magnetic field resonance) between a ground-side device 2 and a vehicle 3. Particularly in the present example the contactless power supply system 1 performs the contactless electric power transmission between the ground-side device 2 and the vehicle 3 while the vehicle 3 is traveling. The ground-side device 2 is an example of a power supply device, and the vehicle 3 is an example of a mobile body. The contactless electric power transmission is also referred to as "contactless power supply", "wireless electric power transmission", or "wireless power supply".

The contactless power supply system 1 includes a power transmission device 4 configured to contactlessly transmit electric power, and a power reception device 5 configured to contactlessly receive the electric power from the power transmission device 4. In the present embodiment, the power transmission device 4 is mounted on the ground-side device 2, and the power reception device 5 is mounted on the vehicle 3. That is, the ground-side device 2 performs contactless power supply to the vehicle 3, and the contactless power supply system 1 contactlessly transmits electric power from the ground-side device 2 to the vehicle 3.

As illustrated in FIG. 1, the ground-side device 2 includes a power supply 21 and a controller 22 in addition to the power transmission device 4. The ground-side device 2 is provided on a road where the vehicle 3 passes, and is, for example, embedded in the ground (under the road surface). At least a part of the ground-side device 2 (for example, the power supply 21 and the controller 22) may be arranged above the road surface.

The power supply 21 is an electric power source of the power transmission device 4 and supplies electric power to the power transmission device 4. Examples of the power supply 21 include a commercial alternating current power supply that supplies singlephase alternating current power. The power supply 21 may be, for example, an alternating current power supply that supplies three-phase alternating current power.

The power transmission device 4 includes a transmission-side rectifier circuit 41, an inverter 42, and a transmission-side resonance circuit 43. In the power transmission device 4, appropriate alternating current power (high-frequency power) is supplied to the transmission-side resonance circuit 43 via the transmission-side rectifier circuit 41 and the inverter 42.

The transmission-side rectifier circuit 41 is electrically connected to the power supply 21 and the inverter 42. The transmission-side rectifier circuit 41 rectifies alternating current power supplied from the power supply 21 to convert the alternating current power into direct current power, and supplies the direct current power to the inverter 42. Examples of the transmission-side rectifier circuit 41 include an alternating current-direct current converter.

The inverter 42 is electrically connected to the transmission-side rectifier circuit 41 and the transmission-side resonance circuit 43. The inverter 42 converts the direct current power supplied from the transmission-side rectifier circuit 41 into alternating current power (high-frequency power) having a frequency higher than that of the alternating current power of the power supply 21, and supplies the high-frequency power to the transmission-side resonance circuit 43.

The transmission-side resonance circuit 43 includes a resonator including a coil 44 and capacitors 45. Various parameters of the coil 44 and the capacitors 45 (outside diameter and bore diameter of the coil 44, number of turns of the coil 44, capacitance of the capacitors 45, etc.) are determined so that the resonance frequency of the transmission-side resonance circuit 43 reaches a predetermined set value. The predetermined set value is, for example, 10 kHz to 100 GHz, preferably 85 kHz defined by the SAE TIR J2954 standard as a frequency band for contactless electric power transmission.

The transmission-side resonance circuit 43 is arranged at the center of a lane where the vehicle 3 passes to position the center of the coil 44 at the center of the lane. When the high-frequency power supplied from the inverter 42 is applied to the transmission-side resonance circuit 43, the transmission-side resonance circuit 43 generates an alternating current magnetic field for transmitting the electric power. The power supply 21 may be a direct current power supply such as a fuel cell or a solar cell. In this case, the transmission-side rectifier circuit 41 may be omitted.

The controller 22 is, for example, a general-purpose computer, and performs various types of control on the ground-side device 2. For example, the controller 22 is electrically connected to the inverter 42 of the power transmission device 4 and controls the inverter 42 to control the electric power transmission by the power transmission device 4.

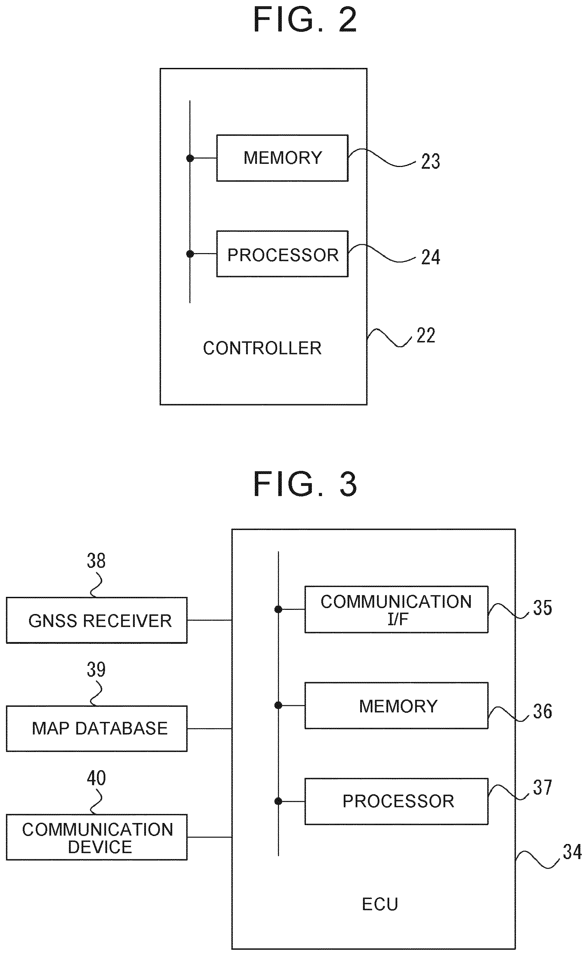

FIG. 2 is a schematic configuration diagram of the controller 22. The controller 22 includes a memory 23 and a processor 24. The memory 23 and the processor 24 are connected to each other via a signal line. The controller 22 may further include, for example, a communication interface that enables communication between the ground-side device 2 and the outside of the ground-side device 2. The controller 22 is an example of a control device of the ground-side device 2.

The memory 23 includes, for example, a volatile semiconductor memory (for example, a random-access memory (RAM)) and a non-volatile semiconductor memory (for example, a read-only memory (ROM)). The memory 23 stores, for example, programs to be executed by the processor 24, and various types of data to be used when various processes are executed by the processor 24.

The processor 24 includes one or more central processing units (CPUs) and their peripheral circuits, and executes various processes. The processor 24 may further include an arithmetic circuit such as a logical operation unit or a numerical operation unit.

As illustrated in FIG. 1, the vehicle 3 includes a motor 31, a battery 32, a power control unit (PCU) 33, and an electronic control unit (ECU) 34 in addition to the power reception device 5. In the present embodiment, the vehicle 3 is a battery electric vehicle (BEV) that is not equipped with an internal combustion engine, and the motor 31 outputs traveling power.

The motor 31 is, for example, an alternating current synchronous motor, and functions as an electric motor and a generator. When the motor 31 functions as the electric motor, the motor 31 is driven by using electric power stored in the battery 32 as a power source. The output of the motor 31 is transmitted to wheels 90 via reducers and axles. When the vehicle 3 is decelerated, the motor 31 is driven by rotation of the wheels 90, and the motor 31 functions as the generator to generate regenerative electric power.

The battery 32 is a rechargeable secondary battery such as a lithium-ion battery or a nickel-metal hydride battery. The battery 32 stores electric power necessary for the vehicle 3 to travel (for example, driving electric power of the motor 31). When the regenerative electric power generated by the motor 31 is supplied to the battery 32, the battery 32 is charged and the charge ratio (state of charge (SOC)) of the battery 32 is recovered. The battery 32 may be charged by an external power supply other than the ground-side device 2 via a charging port provided in the vehicle 3.

The PCU 33 is electrically connected to the battery 32 and the motor 31. The PCU 33 includes an inverter, a boost converter, and a direct current-direct current converter. The inverter converts direct current power supplied from the battery 32 into alternating current power, and supplies the alternating current power to the motor 31. The inverter converts alternating current power (regenerative electric power) generated by the motor 31 into direct current power, and supplies the direct current power to the battery 32. The boost converter boosts a voltage of the battery 32 as needed when the electric power stored in the battery 32 is supplied to the motor 31. The direct current-direct current converter steps down the voltage of the battery 32 when the electric power stored in the battery 32 is supplied to an electronic device such as a headlight.

The power reception device 5 includes a reception-side resonance circuit 51, a reception-side rectifier circuit 54, and a charging circuit 55. The power reception device 5 receives electric power from the power transmission device 4 and supplies the received electric power to the battery 32.

The reception-side resonance circuit 51 is arranged at the bottom of the vehicle 3 to reduce a distance from a road surface. In the present embodiment, the reception-side resonance circuit 51 is arranged at the center of the vehicle 3 in a vehicle width direction, and is arranged between front wheels 90 and rear wheels 90 in a fore-and-aft direction of the vehicle 3.

The reception-side resonance circuit 51 has the same configuration as that of the transmission-side resonance circuit 43, and includes a resonator including a coil 52 and capacitors 53. Various parameters of the coil 52 and the capacitors 53 (outside diameter and bore diameter of the coil 52, number of turns of the coil 52, capacitance of the capacitors 53, etc.) are determined so that the resonance frequency of the reception-side resonance circuit 51 agrees with the resonance frequency of the transmission-side resonance circuit 43. When the amount of deviation between the resonance frequency of the reception-side resonance circuit 51 and the resonance frequency of the transmission-side resonance circuit 43 is small, for example, when the resonance frequency of the reception-side resonance circuit 51 is within a range of ±20% of the resonance frequency of the transmission-side resonance circuit 43, the resonance frequency of the reception-side resonance circuit 51 need not agree with the resonance frequency of the transmission-side resonance circuit 43.

When the alternating current magnetic field is generated in the transmission-side resonance circuit 43 while the reception-side resonance circuit 51 faces the transmission-side resonance circuit 43 as illustrated in FIG. 1, oscillation of the alternating current magnetic field is transmitted to the reception-side resonance circuit 51 that resonates at the same resonance frequency as that of the transmission-side resonance circuit 43. As a result, an induced current flows in the reception-side resonance circuit 51 by electromagnetic induction, and electric power is generated in the reception-side resonance circuit 51 by the induced current. That is, the transmission-side resonance circuit 43 transmits electric power to the reception-side resonance circuit 51, and the reception-side resonance circuit 51 receives the electric power from the transmission-side resonance circuit 43.

The reception-side rectifier circuit 54 is electrically connected to the reception-side resonance circuit 51 and the charging circuit 55. The reception-side rectifier circuit 54 rectifies alternating current power supplied from the reception-side resonance circuit 51 to convert the alternating current power into direct current power, and supplies the direct current power to the charging circuit 55. Examples of the reception-side rectifier circuit 54 include an alternating current-direct current converter.

The charging circuit 55 is electrically connected to the reception-side rectifier circuit 54 and the battery 32. The charging circuit 55 converts the direct current power supplied from the reception-side rectifier circuit 54 into direct current power at a voltage level of the battery 32 and supplies the direct current power to the battery 32. When the electric power transmitted from the power transmission device 4 is supplied to the battery 32 by the power reception device 5, the battery 32 is charged and the SOC of the battery 32 is recovered. Examples of the charging circuit 55 include a direct current-direct current converter.

The ECU 34 performs various types of control on the vehicle 3. For example, the ECU 34 is electrically connected to the charging circuit 55 of the power reception device 5 and controls the charging circuit 55 to control the charging of the battery 32 with the electric power transmitted from the power transmission device 4. The ECU 34 is electrically connected to the PCU 33 and controls the PCU 33 to control the transfer of the electric power between the battery 32 and the motor 31.

FIG. 3 is a schematic configuration diagram of the ECU 34. The ECU 34 includes a communication interface 35, a memory 36, and a processor 37. The communication interface 35, the memory 36, and the processor 37 are connected to each other via a signal line.

The communication interface 35 includes an interface circuit for connecting the ECU 34 to an in-vehicle network conforming to a standard such as a controller area network (CAN).

The memory 36 includes, for example, a volatile semiconductor memory (for example, a RAM) and a non-volatile semiconductor memory (for example, a ROM). The memory 36 stores, for example, programs to be executed by the processor 37, and various types of data to be used when various processes are executed by the processor 37.

The processor 37 includes one or more central processing units (CPUs) and their peripheral circuits, and executes various processes. The processor 37 may further include an arithmetic circuit such as a logical operation unit or a numerical operation unit.

As illustrated in FIG. 3, the vehicle 3 further includes a global navigation satellite system (GNSS) receiver 38, a map database 39, and a communication device 40. The GNSS receiver 38, the map database 39, and the communication device 40 are electrically connected to the ECU 34.

The GNSS receiver 38 detects a current position of the vehicle 3 (for example, a latitude and longitude of the vehicle 3) based on positioning information obtained from a plurality of (for example, three or more) positioning satellites. Specifically, the GNSS receiver 38 captures the positioning satellites and receives radio waves transmitted from the positioning satellites. Then, the GNSS receiver 38 calculates a distance to each positioning satellite based on a difference between a transmission time and a reception time of the radio wave, and detects a current position of the vehicle 3 based on the distance to the positioning satellite and the position of the positioning satellite (orbit information). The output of the GNSS receiver 38, that is, the current position of the vehicle 3 detected by the GNSS receiver 38 is transmitted to the ECU 34.

The global navigation satellite system (GNSS) is a generic term for satellite positioning systems such as the Global Positioning System (GPS) in the United States, the Global Navigation Satellite System (GLONASS) in Russia, Galileo in Europe, the Quasi-Zenith Satellite System (QZSS) in Japan, BeiDou in China, and the Indian Regional Navigation Satellite System (IRNSS) in India. Therefore, the GNSS receiver 38 includes a GPS receiver.

The map database 39 stores map information. The map information includes, for example, position information of an installation area of the ground-side device 2. The ECU 34 acquires the map information from the map database 39. The map database 39 may be provided outside the vehicle 3 (for example, in a server), and the ECU 34 may acquire the map information from the outside of the vehicle 3.

The communication device 40 is a device that enables communication between the vehicle 3 and the outside of the vehicle 3 (for example, a road-to-vehicle communication device or a data communication module (DCM)). The ECU 34 communicates with the outside of the vehicle 3 via the communication device 40.

As described above, the contactless power supply system 1 transmits the electric power from the ground-side device 2 to the vehicle 3 via the alternating current magnetic field generated in the transmission-side resonance circuit 43 of the power transmission device 4. However, constant generation of the alternating current magnetic field for electric power transmission between the ground-side device 2 and the vehicle 3 leads to a waste of electric power. There is also concern about influence of the alternating current magnetic field on electronic devices or the like.

Therefore, it is desirable to generate the alternating current magnetic field for electric power transmission at an appropriate timing when the vehicle 3 passes over the ground-side device 2. In a case where the approach of the vehicle 3 to the ground-side device 2 is detected by wireless communication, however, there is a possibility that the alternating current magnetic field cannot be generated at the appropriate timing due to hindrance to the wireless communication by an obstacle or the like. When the transmission-side resonance circuit 43 and the reception-side resonance circuit 51 are misaligned while the vehicle 3 is passing over the ground-side device 2, the efficiency of electric power transmission decreases.

In the present example the contactless power supply system 1 includes an alternating current magnetic field generation circuit 6 and a magnetic field detector 7, and detects a relative positional relationship between the transmission-side resonance circuit 43 of the power transmission device 4 and the reception-side resonance circuit 51 of the power reception device 5 by using the alternating current magnetic field generation circuit 6 and the magnetic field detector 7. In the present example, as illustrated in FIG. 1, the alternating current magnetic field generation circuit 6 is provided in the vehicle 3, and the magnetic field detector 7 is provided in the ground-side device 2.

The alternating current magnetic field generation circuit 6 generates an alternating current magnetic field for detecting the relative positional relationship between the transmission-side resonance circuit 43 and the reception-side resonance circuit 51 (hereinafter referred to as "position detecting alternating current magnetic field"). The alternating current magnetic field generation circuit 6 is arranged at the bottom of the vehicle 3 to reduce a distance from a road surface. In the present example, the alternating current magnetic field generation circuit 6 is arranged at the center of the vehicle 3 in the vehicle width direction, and is arranged behind the reception-side resonance circuit 51 in the fore-and-aft direction of the vehicle 3. The alternating current magnetic field generation circuit 6 may be arranged at the same position as that of the reception-side resonance circuit 51 or in front of the reception-side resonance circuit 51 in the fore-and-aft direction of the vehicle 3.

The alternating current magnetic field generation circuit 6 has the same configuration as those of the transmission-side resonance circuit 43 and the reception-side resonance circuit 51, and includes a resonator including a coil 61 and capacitors 62. Various parameters of the coil 61 and the capacitors 62 (outside diameter and bore diameter of the coil 61, number of turns of the coil 61, capacitance of the capacitors 62, etc.) are determined so that the resonance frequency of the alternating current magnetic field generation circuit 6 reaches a predetermined set value. The predetermined set value is set to a value different from the resonance frequencies of the transmission-side resonance circuit 43 and the reception-side resonance circuit 51, that is, the resonance frequency of magnetic field resonance coupling.

As illustrated in FIG. 1, the alternating current magnetic field generation circuit 6 is electrically connected to the PCU 33, and the ECU 34 controls the alternating current magnetic field generation circuit 6 via the PCU 33. The inverter of the PCU 33 converts the direct current power supplied from the battery 32 into alternating current power and supplies the alternating current power to the alternating current magnetic field generation circuit 6 based on a command from the ECU 34. When the alternating current power supplied from the PCU 33 is applied to the alternating current magnetic field generation circuit 6, the alternating current magnetic field generation circuit 6 generates the position detecting alternating current magnetic field. That is, the alternating current magnetic field generation circuit 6 generates the alternating current magnetic field as a position signal of the vehicle 3.

For example, the ECU 34 controls the PCU 33 to generate the position detecting alternating current magnetic field by the alternating current magnetic field generation circuit 6 when the distance between the installation area of the ground-side device 2 and the vehicle 3 is equal to or smaller than a predetermined value. The distance between the installation area of the ground-side device 2 and the vehicle 3 is calculated by, for example, comparing the current position of the vehicle 3 detected by the GNSS receiver 38 and the position of the installation area of the ground-side device 2 stored in the map database 39. When a predetermined signal is received from a road-side unit provided before the ground-side device 2 via the communication device 40, the ECU 34 may control the PCU 33 to generate the position detecting alternating current magnetic field by the alternating current magnetic field generation circuit 6. The ECU 34 may constantly generate a feeble alternating current magnetic field by the alternating current magnetic field generation circuit 6 while the vehicle 3 is traveling. The ECU 34 may control the alternating current magnetic field generation circuit 6 via an inverter provided separately from the PCU 33.

The alternating current magnetic field generated by the alternating current magnetic field generation circuit 6 as the position signal of the vehicle 3 may include identification information of the vehicle 3 (for example, a vehicle identifier (ID)). That is, the vehicle 3 may transmit the identification information of the vehicle 3 to the ground-side device 2 via the alternating current magnetic field in addition to the position signal of the vehicle 3. In this case, the ECU 34 of the vehicle 3 transmits the position signal and the identification information of the vehicle 3 to the ground-side device 2 by, for example, modulating the alternating current magnetic field based on the identification information of the vehicle 3 when generating the alternating current magnetic field by the alternating current magnetic field generation circuit 6.

The magnetic field detector 7 detects a magnetic field around the ground-side device 2. Examples of the magnetic field detector 7 include a magneto-impedance (MI) sensor. Driving electric power of the magnetic field detector 7 is supplied to the magnetic field detector 7 from, for example, the power supply 21 via a drive circuit. The magnetic field detector 7 may be a Hall sensor, a magneto-resistive (MR) sensor, or the like.

The magnetic field detector 7 is arranged before the transmission-side resonance circuit 43 of the power transmission device 4 in the traveling direction of the vehicle 3 on a road provided with the power transmission device 4, and is arranged at the center of a lane where the vehicle 3 passes. The magnetic field detector 7 is arranged in the ground (below a road surface) or above the road surface. When the position detecting alternating current magnetic field is generated from the vehicle 3 around the magnetic field detector 7, the magnetic field detector 7 detects the position detecting alternating current magnetic field.

The magnetic field detector 7 is electrically connected to the controller 22, and the output of the magnetic field detector 7 is transmitted to the controller 22. In the present embodiment, the contactless power supply system 1 includes the controller 22, and the controller 22 controls the contactless power supply between the ground-side device 2 and the vehicle 3.

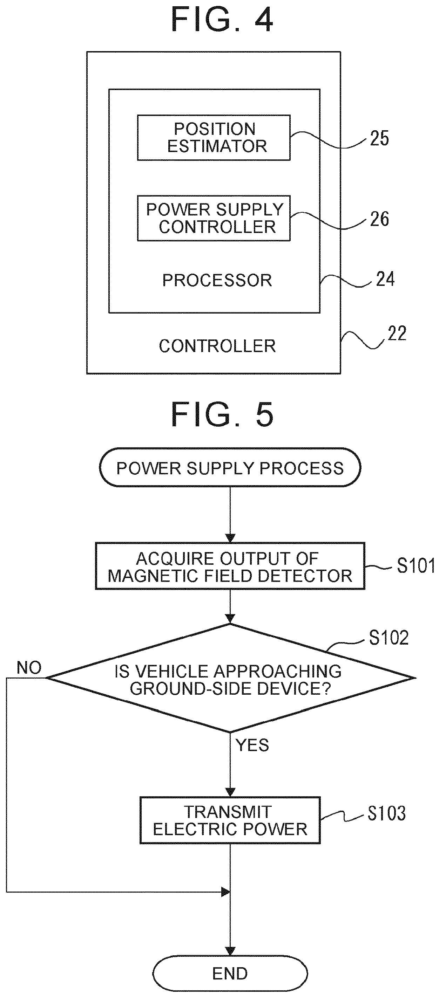

FIG. 4 is a functional block diagram of the processor 24 of the controller 22. In the present embodiment, the processor 24 includes a position estimator 25 and a power supply controller 26. The position estimator 25 and the power supply controller 26 are functional modules implemented by the processor 24 of the controller 22 executing a computer program stored in the memory 23 of the controller 22. The position estimator 25 and the power supply controller 26 may be implemented by a dedicated arithmetic circuit provided in the processor 24.

The position estimator 25 estimates the relative positional relationship between the transmission-side resonance circuit 43 and the reception-side resonance circuit 51 based on the output of the magnetic field detector 7. Specifically, the position estimator 25 extracts an alternating current magnetic field of a specific frequency from the output of the magnetic field detector 7, and estimates the relative positional relationship between the transmission-side resonance circuit 43 and the reception-side resonance circuit 51 based on the extracted alternating current magnetic field of the specific frequency. The specific frequency is a frequency of the AC magnetic field generated from the vehicle 3 as the position signal, and corresponds to a frequency of the alternating current magnetic field to be detected. That is, the position estimator 25 estimates the relative positional relationship between the transmission-side resonance circuit 43 and the reception-side resonance circuit 51 by detecting the position detecting alternating current magnetic field generated from the alternating current magnetic field generation circuit 6.

In the present embodiment, the influence of obstacles in the transmission and reception of signals can be reduced by using the alternating current magnetic field as the position detecting signal. Even when a stationary magnetic field (direct current magnetic field) is generated by a metal or the like present around the ground-side device 2, it is easy to distinguish the stationary magnetic field and the position detecting signal (alternating current magnetic field).

In the present embodiment, the frequency of the position detecting alternating current magnetic field is different from the resonance frequencies of the transmission-side resonance circuit 43 and the reception-side resonance circuit 51. Therefore, it is easy to distinguish the alternating current magnetic field generated in the transmission-side resonance circuit 43 for electric power transmission and the alternating current magnetic field generated in the alternating current magnetic field generation circuit 6 for position detection. By using the alternating current magnetic field having the frequency different from that of the alternating current magnetic field for electric power transmission as the position detecting signal, the relative positional relationship between the transmission-side resonance circuit 43 and the reception-side resonance circuit 51 can be detected accurately.

The frequency of the position detecting alternating current magnetic field is preferably set to a value lower than the resonance frequencies of the transmission-side resonance circuit 43 and the reception-side resonance circuit 51. Thus, the position detecting alternating current magnetic field can be generated more easily. For example, when the resonance frequencies of the transmission-side resonance circuit 43 and the reception-side resonance circuit 51 are 85 kHz, the frequency of the position detecting alternating current magnetic field is set to 50 Hz to 50 kHz, for example, 1 kHz.

In the present example the transmission-side resonance circuit 43 and the magnetic field detector 7 are provided in the ground-side device 2, and the reception-side resonance circuit 51 and the alternating current magnetic field generation circuit 6 are provided in the vehicle 3. That is, the transmission-side resonance circuit 43 and the magnetic field detector 7 are provided in one of the vehicle 3 and the ground-side device 2, and the reception-side resonance circuit 51 and the alternating current magnetic field generation circuit 6 are provided in the other of the vehicle 3 and the ground-side device 2. In this case, the source of the electric power transmission alternating current magnetic field and the source of the position detecting alternating current magnetic field are different. Therefore, the temporal change in the signal strength detected by the magnetic field detector 7 differs between the position detecting alternating current magnetic field and the electric power transmission alternating current magnetic field. As a result, the position detecting alternating current magnetic field and the electric power transmission alternating current magnetic field can be distinguished more easily, and furthermore, the relative positional relationship between the transmission-side resonance circuit 43 and the reception-side resonance circuit 51 can be detected more accurately.

When the alternating current magnetic field generated by the alternating current magnetic field generation circuit 6 includes the identification information of the vehicle 3, the position estimator 25 acquires the identification information of the vehicle 3 from the output of the magnetic field detector 7. Thus, the vehicle 3 to be supplied with electric power can be identified. As a result, the vehicle 3 can easily be, for example, billed for a power supply fee.

The power supply controller 26 controls the contactless electric power transmission between the ground-side device 2 and the vehicle 3 based on the relative positional relationship between the transmission-side resonance circuit 43 and the reception-side resonance circuit 51 estimated by the position estimator 25. That is, the power supply controller 26 controls the electric power transmission from the transmission-side resonance circuit 43 of the power transmission device 4 to the reception-side resonance circuit 51 of the power reception device 5 based on the estimation result from the position estimator 25. For example, the power supply controller 26 starts the electric power transmission from the transmission-side resonance circuit 43 to the reception-side resonance circuit 51 when the position estimator 25 detects that the vehicle 3 including the reception-side resonance circuit 51 is approaching the ground-side device 2.

The control flow described above will be described below with reference to a flowchart of FIG. 5. FIG. 5 is a flowchart illustrating a control routine of a power supply process according to the first example of the present invention. This control routine is repeatedly executed by the processor 24 of the controller 22.

In Step S101, the position estimator 25 first acquires an output of the magnetic field detector 7.

In Step S102, the position estimator 25 determines, based on the output of the magnetic field detector 7, whether the vehicle 3 is approaching the ground-side device 2, that is, whether the reception-side resonance circuit 51 is approaching the transmission-side resonance circuit 43. For example, the position estimator 25 performs frequency analysis on the output of the magnetic field detector 7 to extract a frequency component of the position detecting alternating current magnetic field, and determines that the vehicle 3 is approaching the ground-side device 2 when the value (peak value) of the extracted frequency component is equal to or larger than a predetermined value. Examples of the method for the frequency analysis include Fourier transform.

When determination is made in Step S102 that the vehicle 3 is not approaching the ground-side device 2, this control routine is terminated. When determination is made in Step S102 that the vehicle 3 is approaching the ground-side device 2, this control routine proceeds to Step S103.

In Step S103, the power supply controller 26 transmits electric power from the ground-side device 2 to the vehicle 3. Specifically, the power supply controller 26 controls the inverter 42 of the power transmission device 4 to supply high-frequency power to the transmission-side resonance circuit 43, thereby transmitting the electric power from the transmission-side resonance circuit 43 to the reception-side resonance circuit 51.

For example, the power supply controller 26 transmits the electric power from the transmission-side resonance circuit 43 to the reception-side resonance circuit 51 for a predetermined period. The predetermined period is determined in advance in consideration of a period for the vehicle 3 to pass over the ground-side device 2. The power supply controller 26 may stop the electric power transmission from the transmission-side resonance circuit 43 to the reception-side resonance circuit 51 when the passage of the vehicle 3 over the ground-side device 2 is detected. In this case, for example, the magnetic field detectors 7 are provided in front of and behind the transmission-side resonance circuit 43 in the traveling direction of the vehicle 3, and the passage of the vehicle 3 over the ground-side device 2 is detected based on the output of the magnetic field detector 7 in front of the transmission-side resonance circuit 43. The passage of the vehicle 3 may be detected by, for example, road-to-vehicle communication between the vehicle 3 and a road-side unit. After Step S103, this control routine is terminated.

Next, a second embodiment of the present invention will be described. The configuration and control of a contactless power supply system according to the second embodiment are basically the same as the configuration and control of the contactless power supply system according to the first embodiment except for points described below. Therefore, the second embodiment of the present invention will be described below focusing on the differences from the first embodiment.

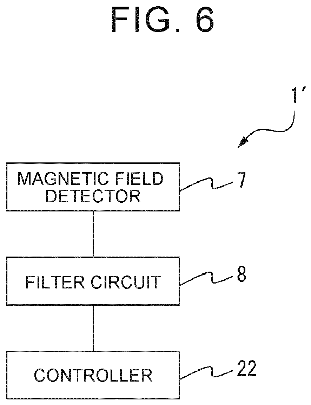

FIG. 6 is a diagram schematically illustrating a part of a configuration of a contactless power supply system 1' according to the second embodiment of the present invention. In the second embodiment, the contactless power supply system 1' further includes a filter circuit 8 that filters the output of the magnetic field detector 7.

The filter circuit 8 is provided between the magnetic field detector 7 and the controller 22 in the ground-side device 2, and is electrically connected to the magnetic field detector 7 and the controller 22. The filter circuit 8 passes a signal having the frequency of the position detecting alternating current magnetic field and attenuates a signal having the resonance frequency of each of the transmission-side resonance circuit 43 and the reception-side resonance circuit 51.

The position estimator 25 of the controller 22 acquires the output of the magnetic field detector 7 filtered by the filter circuit 8, that is, the output of the magnetic field detector 7 corresponding to the frequency component of the position detecting alternating current magnetic field. Then, the position estimator 25 estimates the relative positional relationship between the transmission-side resonance circuit 43 and the reception-side resonance circuit 51 based on the filtered output of the magnetic field detector 7. Therefore, in the second embodiment, the frequency analysis for the magnetic field detector 7 is omitted or simplified, thereby reducing the calculation load on the controller 22 for position detection.

When the frequency of the position detecting alternating current magnetic field is higher than the resonance frequencies of the transmission-side resonance circuit 43 and the reception-side resonance circuit 51, for example, a high-pass filter (HPF) is used as the filter circuit 8. When the frequency of the position detecting alternating current magnetic field is lower than the resonance frequencies of the transmission-side resonance circuit 43 and the reception-side resonance circuit 51, for example, a low-pass filter (LPF) is used as the filter circuit 8. The filter circuit 8 may be a bandpass filter (BPF) that passes only signals in a specific frequency band that includes the frequency of the position detecting alternating current magnetic field and does not include the frequency of the electric power transmission alternating current magnetic field. Thus, the frequency component of the position detecting alternating current magnetic field can be extracted more accurately from the output of the magnetic field detector 7.

Also in the second embodiment, the control routine of FIG. 5 is executed. In Step S101, the position estimator 25 acquires the output of the magnetic field detector 7 filtered by the filter circuit 8. In Step S102, the position estimator 25 determines whether the vehicle 3 is approaching the ground-side device 2 based on the filtered output of the magnetic field detector 7.

Next, a third embodiment of the present invention will be described. The configuration and control of a contactless power supply system according to the third embodiment are basically the same as the configuration and control of the contactless power supply system according to the first example except for points described below. Therefore, the third embodiment of the present invention will be described below focusing on the differences from the first example.

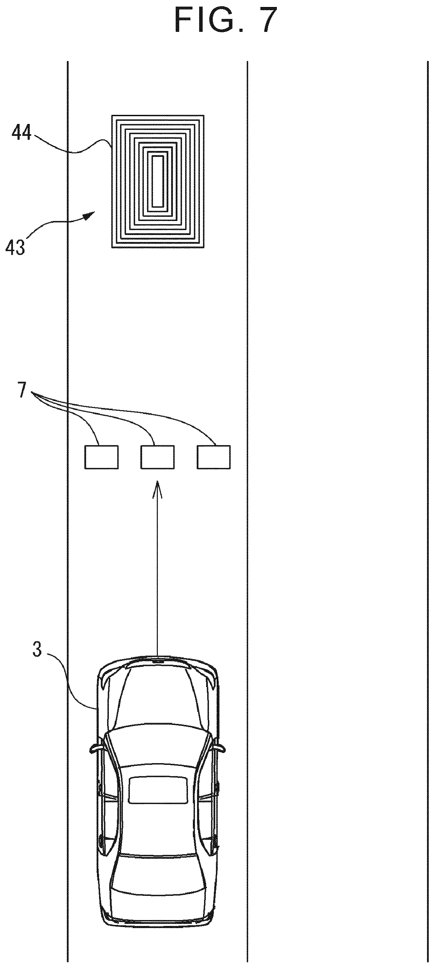

FIG. 7 is a diagram illustrating an example of arrangement of the magnetic field detectors 7 according to the third embodiment of the present invention. In the third embodiment, a plurality of magnetic field detectors 7 is provided along a direction perpendicular to the traveling direction of the vehicle 3. That is, the contactless power supply system 1 includes the plurality of magnetic field detectors 7, and the magnetic field detectors 7 are provided in the ground-side device 2. The magnetic field detectors 7 are spaced away from each other along the direction perpendicular to the traveling direction of the vehicle 3. For example, the magnetic field detectors 7 are arranged at equal intervals along the direction perpendicular to the traveling direction of the vehicle 3.

As described above, the reception-side resonance circuit 51 and the alternating current magnetic field generation circuit 6 provided in the vehicle 3 are arranged at the center of the vehicle 3 in the vehicle width direction, and the transmission-side resonance circuit 43 is arranged at the center of a lane where the vehicle 3 passes to position the center of the coil 44 at the center of the lane. Therefore, one of the magnetic field detectors 7 is arranged at the center of the lane where the vehicle 3 passes. Thus, one of the magnetic field detectors 7 is arranged at the same position as that of the transmission-side resonance circuit 43 in the direction perpendicular to the traveling direction of the vehicle 3. In the example of FIG. 7, the magnetic field detector 7 is arranged at the center of the lane, and the magnetic field detectors 7 are arranged on the right and left sides of the central magnetic field detector 7. Therefore, a total of three magnetic field detectors 7 are arranged at equal intervals.

When the reception-side resonance circuit 51 and the transmission-side resonance circuit 43 are misaligned while the vehicle 3 is passing over the ground-side device 2, that is, when the vehicle 3 is traveling with displacement from the center of the lane, the efficiency of electric power transmission from the transmission-side resonance circuit 43 to the reception-side resonance circuit 51 decreases. In the third embodiment, the power supply controller 26 prohibits the electric power transmission from the transmission-side resonance circuit 43 to the reception-side resonance circuit 51 when the reception-side resonance circuit 51 and the transmission-side resonance circuit 43 are misaligned in the direction perpendicular to the traveling direction of the vehicle 3. As a result, it is possible to suppress the transmission of electric power while the efficiency of electric power transmission decreases, and furthermore, reduce the waste of power consumption in the power transmission device 4.

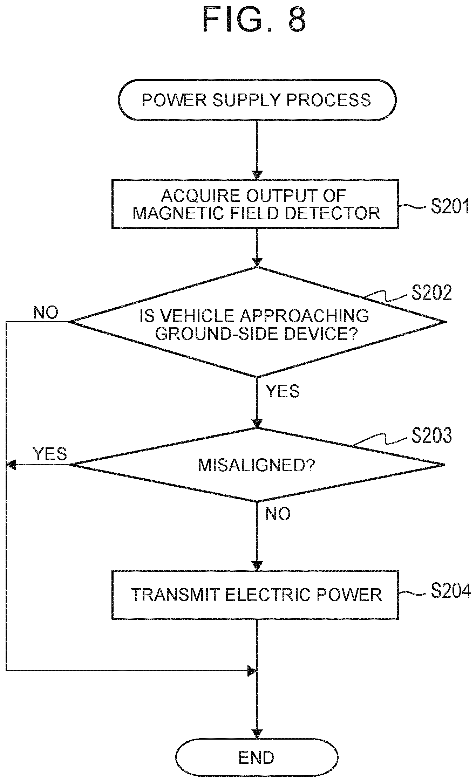

FIG. 8 is a flowchart illustrating a control routine of a power supply process according to the third embodiment of the present invention. This control routine is repeatedly executed by the processor 24 of the controller 22.

In Step S201, the position estimator 25 first acquires outputs of the magnetic field detectors 7.

In Step S202, the position estimator 25 determines whether the vehicle 3 is approaching the ground-side device 2 similarly to Step S102 in FIG. 5. For example, the position estimator 25 determines that the vehicle 3 is approaching the ground-side device 2 when the value (peak value) of the frequency component of the position detecting alternating current magnetic field in the output of at least one of the magnetic field detectors 7 is equal to or larger than the predetermined value.

When determination is made in Step S202 that the vehicle 3 is not approaching the ground-side device 2, this control routine is terminated. When determination is made in Step S202 that the vehicle 3 is approaching the ground-side device 2, this control routine proceeds to Step S203.

In Step S203, the position estimator 25 determines whether the reception-side resonance circuit 51 and the transmission-side resonance circuit 43 are misaligned in the direction perpendicular to the traveling direction of the vehicle 3. For example, the position estimator 25 determines that the reception-side resonance circuit 51 and the transmission-side resonance circuit 43 are misaligned when the output of the magnetic field detector 7 arranged at the center of the lane is not maximum among the outputs of the magnetic field detectors 7, that is, when the output of the magnetic field detector 7 arranged at a position other than the center of the lane is maximum. The position estimator 25 may determine that the reception-side resonance circuit 51 and the transmission-side resonance circuit 43 are misaligned when the output of the magnetic field detector 7 arranged on the outermost side in a width direction of the lane is maximum. The position estimator 25 may calculate an amount of misalignment between the reception-side resonance circuit 51 and the transmission-side resonance circuit 43 based on the outputs of the magnetic field detectors 7, and determine that the reception-side resonance circuit 51 and the transmission-side resonance circuit 43 are misaligned when the calculated misalignment amount is equal to or larger than a predetermined value.

When determination is made in Step S203 that the reception-side resonance circuit 51 and the transmission-side resonance circuit 43 are misaligned, this control routine is terminated. That is, the electric power transmission from the transmission-side resonance circuit 43 to the reception-side resonance circuit 51 is prohibited when the vehicle 3 passes over the ground-side device 2.

When determination is made in Step S203 that the reception-side resonance circuit 51 and the transmission-side resonance circuit 43 are not misaligned, this control routine proceeds to Step S204. In Step S204, the power supply controller 26 transmits electric power from the ground-side device 2 to the vehicle 3 similarly to Step S103 in FIG. 5. After Step S204, this control routine is terminated.

Next, a fourth embodiment of the present invention will be described. The configuration and control of a contactless power supply system according to the fourth embodiment are basically the same as the configuration and control of the contactless power supply system according to the first example except for points described below. Therefore, the fourth embodiment of the present invention will be described below focusing on the differences from the first example.

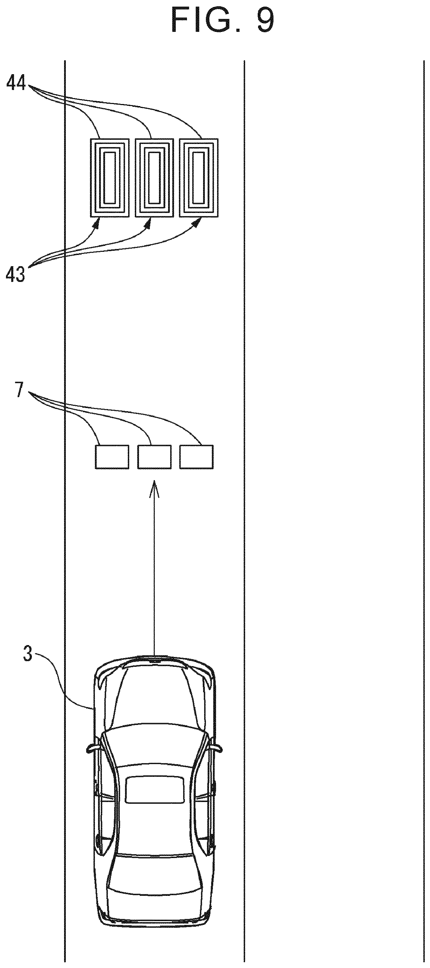

FIG. 9 is a diagram illustrating an example of arrangement of the magnetic field detectors 7 and the transmission-side resonance circuits 43 according to the fourth embodiment of the present invention. In the fourth embodiment, the magnetic field detectors 7 are provided along the direction perpendicular to the traveling direction of the vehicle 3 similarly to the third embodiment.

In the fourth embodiment, a plurality of transmission-side resonance circuits 43 of the power transmission device 4 as well as the magnetic field detectors 7 is provided along the direction perpendicular to the traveling direction of the vehicle 3. That is, the contactless power supply system 1 includes the plurality of transmission-side resonance circuits 43, and the transmission-side resonance circuits 43 are provided in the ground-side device 2. The transmission-side resonance circuits 43 are spaced away from each other along the direction perpendicular to the traveling direction of the vehicle 3. For example, the transmission-side resonance circuits 43 are arranged at equal intervals along the direction perpendicular to the traveling direction of the vehicle 3.

As described above, the reception-side resonance circuit 51 provided in the vehicle 3 is arranged at the center of the vehicle 3 in the vehicle width direction. Therefore, one of the transmission-side resonance circuits 43 is arranged at the center of a lane of the road where the vehicle 3 passes. In the example of FIG. 9, the transmission-side resonance circuit 43 is arranged at the center of the lane, and the transmission-side resonance circuits 43 are arranged on the right and left sides of the central transmission-side resonance circuit 43. Therefore, a total of three transmission-side resonance circuits 43 are arranged at equal intervals. That is, the number of transmission-side resonance circuits 43 is equal to the number of magnetic field detectors 7.

When the plurality of transmission-side resonance circuits 43 is arranged in the vehicle width direction, the transmission-side resonance circuit 43 closest to the reception-side resonance circuit 51 provided in the vehicle 3 differs depending on a lateral position of the vehicle 3. For example, when the vehicle 3 is traveling with displacement to the right in the traveling direction, the right transmission-side resonance circuit 43 is closest to the reception-side resonance circuit 51. When the vehicle 3 is traveling with displacement to the left in the traveling direction, the left transmission-side resonance circuit 43 is closest to the reception-side resonance circuit 51.

In the fourth embodiment, the power supply controller 26 switches the transmission-side resonance circuit 43 that transmits electric power to the reception-side resonance circuit 51 based on the relative positional relationship between the transmission-side resonance circuit 43 and the reception-side resonance circuit 51 in the direction perpendicular to the traveling direction of the vehicle 3. As a result, it is possible to suppress the decrease in the efficiency of electric power transmission due to the misalignment between the reception-side resonance circuit 51 and the transmission-side resonance circuit 43, and furthermore, reduce the waste of power consumption in the power transmission device 4.

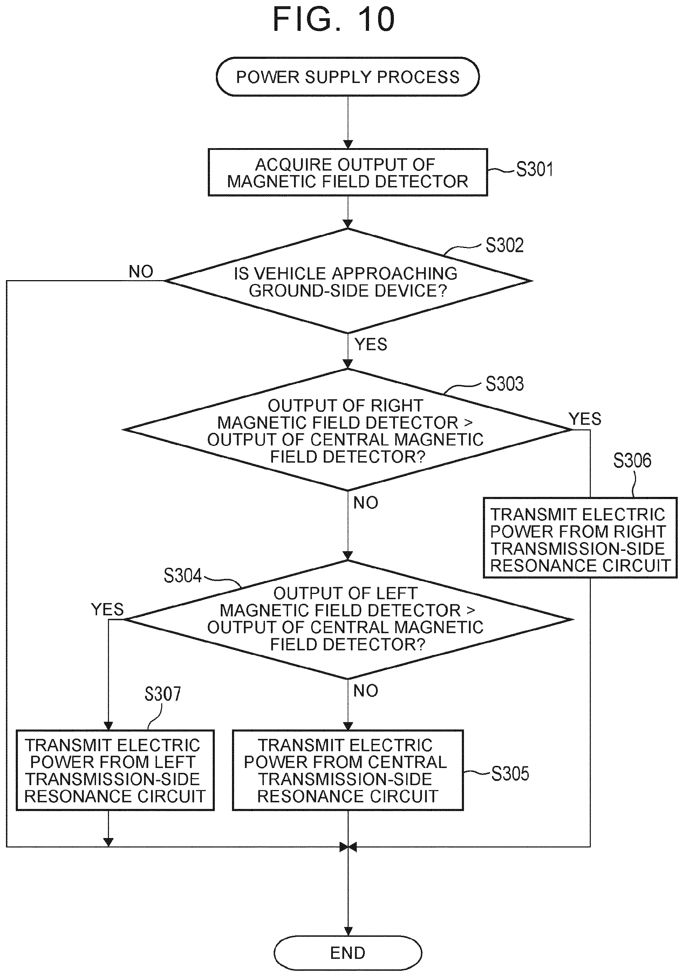

FIG. 10 is a flowchart illustrating a control routine of a power supply process according to the fourth embodiment of the present invention. This control routine is repeatedly executed by the processor 24 of the controller 22.

Steps S301 and S302 are executed similarly to Steps S201 and S202 in FIG. 8. When determination is made in Step S302 that the vehicle 3 is approaching the ground-side device 2, this control routine proceeds to Step S303.

In Step S303, the position estimator 25 determines whether the output of the magnetic field detector 7 on the right side in the traveling direction of the vehicle 3 is larger than the output of the magnetic field detector 7 at the center of the lane in terms of the frequency component of the position detecting alternating current magnetic field. When determination is made that the output of the right magnetic field detector 7 is equal to or smaller than the output of the central magnetic field detector 7, this control routine proceeds to Step S304.

In Step S304, the position estimator 25 determines whether the output of the magnetic field detector 7 on the left side in the traveling direction of the vehicle 3 is larger than the output of the magnetic field detector 7 at the center of the lane in terms of the frequency component of the position detecting alternating current magnetic field. When determination is made that the output of the left magnetic field detector 7 is equal to or smaller than the output of the central magnetic field detector 7, that is, when the output of the central magnetic field detector 7 is maximum, the position estimator 25 determines that the vehicle 3 is not displaced and this control routine proceeds to Step S305.

In Step S305, the power supply controller 26 transmits electric power from the transmission-side resonance circuit 43 at the center of the lane to the reception-side resonance circuit 51. Specifically, the power supply controller 26 controls the inverter 42 of the power transmission device 4 to supply high-frequency power to the transmission-side resonance circuit 43 at the center of the lane. After Step S305, this control routine is terminated.

When determination is made in Step S303 that the output of the right magnetic field detector 7 is larger than the output of the central magnetic field detector 7, the position estimator 25 determines that the vehicle 3 is displaced to the right in the traveling direction and this control routine proceeds to Step S306. In Step S306, the power supply controller 26 transmits electric power from the transmission-side resonance circuit 43 on the right side in the traveling direction of the vehicle 3 to the reception-side resonance circuit 51. Specifically, the power supply controller 26 controls the inverter 42 of the power transmission device 4 to supply high-frequency power to the right transmission-side resonance circuit 43. After Step S306, this control routine is terminated.

When determination is made in Step S304 that the output of the left magnetic field detector 7 is larger than the output of the central magnetic field detector 7, the position estimator 25 determines that the vehicle 3 is displaced to the left in the traveling direction and this control routine proceeds to Step S307. In Step S307, the power supply controller 26 transmits electric power from the transmission-side resonance circuit 43 on the left side in the traveling direction of the vehicle 3 to the reception-side resonance circuit 51. Specifically, the power supply controller 26 controls the inverter 42 of the power transmission device 4 to supply high-frequency power to the left transmission-side resonance circuit 43. After Step S307, this control routine is terminated.

In Step S305, the power supply controller 26 may transmit the electric power from all the transmission-side resonance circuits 43 to the reception-side resonance circuit 51. In Step S306, the power supply controller 26 may transmit the electric power to the reception-side resonance circuit 51 from the transmission-side resonance circuit 43 on the right side in the traveling direction of the vehicle 3 and the transmission-side resonance circuit 43 at the center of the lane. In Step S307, the power supply controller 26 may transmit the electric power to the reception-side resonance circuit 51 from the transmission-side resonance circuit 43 on the left side in the traveling direction of the vehicle 3 and the transmission-side resonance circuit 43 at the center of the lane.

Next, an embodiment of the present invention will be described. The configuration and control of a contactless power supply system according to the embodiment are basically the same as the configuration and control of the contactless power supply system according to the first example except for points described below. Therefore, the fifth embodiment of the present invention will be described below focusing on the differences from the first example.

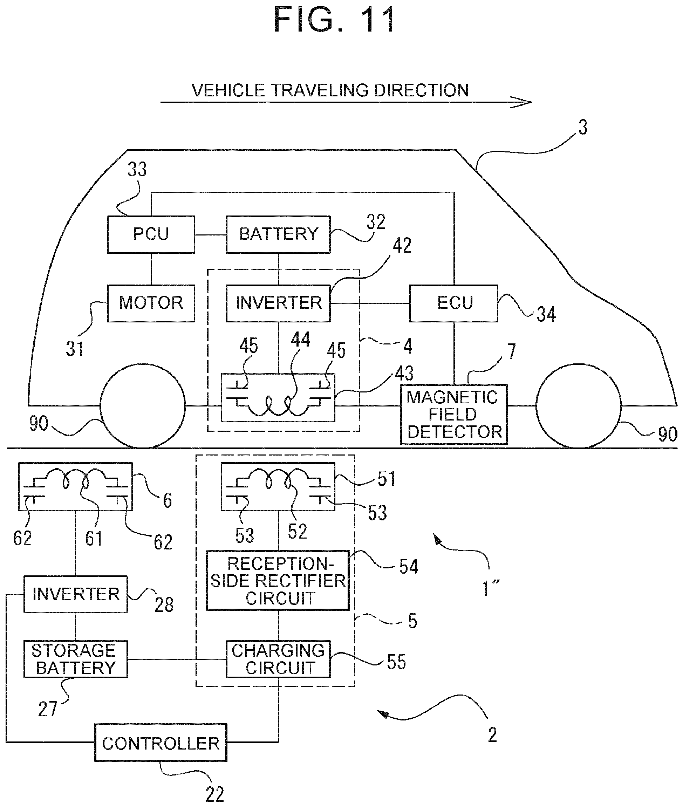

FIG. 11 is a diagram schematically illustrating a configuration of a contactless power supply system 1" according to the embodiment of the present invention. As described above, the battery 32 of the vehicle 3 can be charged with the regenerative electric power generated by the motor 31. When the SOC of the battery 32 is high, however, the regenerative electric power cannot be supplied to the battery 32. When the SOC of the battery 32 is kept high, deterioration of the battery 32 is advanced. Therefore, there is a need to reduce the SOC of the battery 32 while the vehicle 3 is traveling.

In the embodiment, the power transmission device 4 is mounted on the vehicle 3 and the power reception device 5 is mounted on the ground-side device 2 unlike the first example. That is, the contactless power supply system 1" contactlessly transmits the electric power from the vehicle 3 to the ground-side device 2 while the vehicle 3 is traveling.

In the embodiment, the power transmission device 4 includes the inverter 42 and the transmission-side resonance circuit 43. The battery 32 is used as the electric power source of the power transmission device 4, and the electric power of the battery 32 is consumed by electric power transmission from the vehicle 3 to the ground-side device 2.

The inverter 42 is electrically connected to the battery 32 and the transmission-side resonance circuit 43. The inverter 42 converts the direct current power supplied from the battery 32 into high-frequency power, and supplies the high-frequency power to the transmission-side resonance circuit 43. When the high-frequency power supplied from the inverter 42 is applied to the transmission-side resonance circuit 43, the transmission-side resonance circuit 43 generates an alternating current magnetic field for transmitting the electric power. The ECU 34 is electrically connected to the inverter 42 of the power transmission device 4 and controls the inverter 42 to control the electric power transmission by the power transmission device 4. The inverter 42 may be omitted and the PCU 33 may electrically be connected to the transmission-side resonance circuit 43 to function as an inverter of the power transmission device 4.

The power reception device 5 includes the reception-side resonance circuit 51, the reception-side rectifier circuit 54, and the charging circuit 55 similarly to the first embodiment. The ground-side device 2 includes a storage battery 27, and the electric power transmitted from the power transmission device 4 to the power reception device 5 is supplied to the storage battery 27. The storage battery 27 is a rechargeable secondary battery such as a lithium-ion battery or a nickel-metal hydride battery.

When the alternating current magnetic field is generated in the transmission-side resonance circuit 43 while the reception-side resonance circuit 51 faces the transmission-side resonance circuit 43 as illustrated in FIG. 11, oscillation of the alternating current magnetic field is transmitted to the reception-side resonance circuit 51 that resonates at the same resonance frequency as that of the transmission-side resonance circuit 43. As a result, an induced current flows in the reception-side resonance circuit 51 by electromagnetic induction, and electric power is generated in the reception-side resonance circuit 51 by the induced current. That is, the transmission-side resonance circuit 43 transmits electric power to the reception-side resonance circuit 51, and the reception-side resonance circuit 51 receives the electric power from the transmission-side resonance circuit 43.

The charging circuit 55 is electrically connected to the reception-side rectifier circuit 54 and the storage battery 27. The charging circuit 55 converts the direct current power supplied from the reception-side rectifier circuit 54 into direct current power at a voltage level of the storage battery 27 and supplies the direct current power to the storage battery 27. When the electric power transmitted from the power transmission device 4 is supplied to the storage battery 27 by the power reception device 5, the storage battery 27 is charged.

In the embodiment, the alternating current magnetic field generation circuit 6 is provided in the ground-side device 2, and the magnetic field detector 7 is provided in the vehicle 3. The alternating current magnetic field generation circuit 6 is arranged at the center of the lane where the vehicle 3 passes, and is arranged before the reception-side resonance circuit 51 in the traveling direction of the vehicle 3. The alternating current magnetic field generation circuit 6 may be arranged at the same position as that of the reception-side resonance circuit 51 or in front of the reception-side resonance circuit 51 in the traveling direction of the vehicle 3.

The ground-side device 2 includes an inverter 28, and the alternating current magnetic field generation circuit 6 generates the position detecting alternating current magnetic field by using electric power supplied from the inverter 28. The inverter 28 is electrically connected to the storage battery 27 and the alternating current magnetic field generation circuit 6. The controller 22 is electrically connected to the inverter 28 and controls the alternating current magnetic field generation circuit 6 via the inverter 28.

The inverter 28 converts the direct current power supplied from the storage battery 27 into alternating current power and supplies the alternating current power to the alternating current magnetic field generation circuit 6 based on a command from the controller 22. When the alternating current power supplied from the inverter 28 is applied to the alternating current magnetic field generation circuit 6, the alternating current magnetic field generation circuit 6 generates the position detecting alternating current magnetic field.

For example, when a road-side unit provided before the ground-side device 2 detects the vehicle 3 and the controller 22 receives a signal from the road-side unit, the controller 22 controls the inverter 28 to generate the position detecting alternating current magnetic field by the alternating current magnetic field generation circuit 6. The controller 22 may constantly generate a feeble alternating current magnetic field by the alternating current magnetic field generation circuit 6 in a predetermined time frame (for example, a time frame other than nighttime) or all day long.

As illustrated in FIG. 11, the magnetic field detector 7 is arranged in front of the transmission-side resonance circuit 43 in the vehicle 3. The magnetic field detector 7 is electrically connected to the ECU 34, and the output of the magnetic field detector 7 is transmitted to the ECU 34. In the embodiment, the contactless power supply system 1" includes the ECU 34, and the ECU 34 controls the contactless power supply between the ground-side device 2 and the vehicle 3.

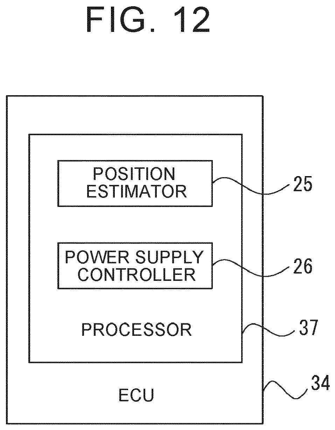

FIG. 12 is a functional block diagram of the processor 37 of the ECU 34. In the present embodiment, the processor 37 includes the position estimator 25 and the power supply controller 26. The position estimator 25 and the power supply controller 26 are functional modules implemented by the processor 37 of the ECU 34 executing a computer program stored in the memory 36 of the ECU 34. The position estimator 25 and the power supply controller 26 may be implemented by a dedicated arithmetic circuit provided in the processor 37.

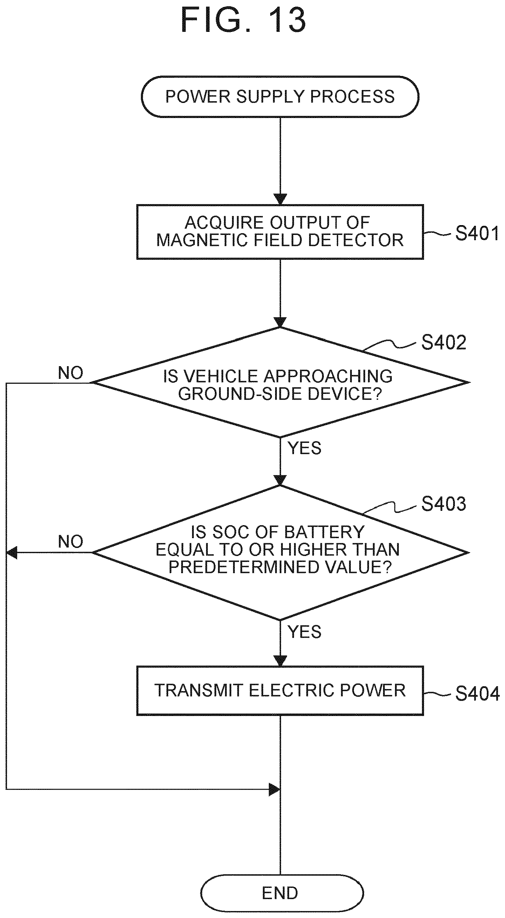

FIG. 13 is a flowchart illustrating a control routine of a power supply process according to the embodiment of the present invention. This control routine is repeatedly executed by the processor 37 of the ECU 34.

Steps S401 and S402 are executed similarly to Steps S101 and S102 in FIG. 5. When determination is made in Step S402 that the vehicle 3 is approaching the ground-side device 2, this control routine proceeds to Step S403.

In Step S403, the power supply controller 26 determines whether the SOC of the battery 32 of the vehicle 3 is equal to or higher than a predetermined value. The predetermined value is set to, for example, an upper limit of a value at which the regenerative electric power can be collected.

The SOC of the battery 32 is calculated by a known method. For example, a battery sensor for detecting state parameters of the battery 32 is provided in the battery 32, and the power supply controller 26 calculates the SOC of the battery 32 based on a voltage and temperature of the battery 32 detected by the battery sensor. The power supply controller 26 may calculate the SOC of the battery 32 by integrating input and output currents of the battery 32 detected by the battery sensor. The power supply controller 26 may calculate the SOC of the battery 32 by using a state estimation method such as a Kalman filter.

When determination is made in Step S403 that the SOC of the battery 32 is lower than the predetermined value, this control routine is terminated. When determination is made in Step S403 that the SOC of the battery 32 is equal to or higher than the predetermined value, this control routine proceeds to Step S404.

In Step S404, the power supply controller 26 transmits electric power from the vehicle 3 to the ground-side device 2. Specifically, similarly to Step S103 in FIG. 5, the power supply controller 26 controls the inverter 42 of the power transmission device 4 to supply high-frequency power to the transmission-side resonance circuit 43, thereby transmitting the electric power from the transmission-side resonance circuit 43 to the reception-side resonance circuit 51. After Step S404, this control routine is terminated.

Next, other embodiments of the present invention will be described. Although the preferred embodiments of the present invention have been described above, the present invention is not limited to these embodiments, and various revisions and modifications may be made within the scope of the claims. For example, the configurations of the resonators of the transmission-side resonance circuit 43, the reception-side resonance circuit 51, and the alternating current magnetic field generation circuit 6 are only illustrative. For example, the numbers of capacitors 45, 53, and 62 may be one. Since the alternating current magnetic field generation circuit 6 that generates the position detecting alternating current magnetic field need not use the magnetic field resonance coupling, the capacitors 62 may be omitted.

The vehicle 3 may be a hybrid electric vehicle (HEV) or a plug-in hybrid electric vehicle (PHEV) including an internal combustion engine and a motor as traveling power sources. The vehicle 3 may be an autonomous driving vehicle in which at least a part of acceleration, steering, and deceleration (braking) of the vehicle 3 is controlled autonomously. The mobile body that transfers electric power with the ground-side device 2 may be a commercial vehicle such as a bus or a truck, an automated guided vehicle (AGV), a drone, or the like.

In the first example illustrated in FIG. 1, the alternating current magnetic field generation circuit 6 may be provided in the ground-side device 2, and the magnetic field detector 7 and the position estimator 25 may be provided in the vehicle 3. In this case, for example, the relative positional relationship between the transmission-side resonance circuit 43 and the reception-side resonance circuit 51 estimated by the position estimator 25 based on the output of the magnetic field detector 7 is presented to a driver via a display device (human-machine interface (HMI) or the like) of the vehicle 3. As a result, the driver can, for example, decelerate or steer the vehicle 3 as necessary to increase the amount of electric power transmission. The vehicle 3 may automatically be controlled to increase the amount of electric power transmission based on the estimation result from the position estimator 25.

The examples and embodiment described above may be implemented in any combination. For example, in the third to fifth embodiments, the filter circuit 8 may be provided between the magnetic field detector 7 and the controller 22 or between the magnetic field detector 7 and the ECU 34 similarly to the second example.

The embodiment may be combined with the third embodiment, and the vehicle 3 may include a plurality of magnetic field detectors 7 spaced away from each other along the vehicle width direction of the vehicle 3. Also in this case, the magnetic field detectors 7 are provided along the direction perpendicular to the traveling direction of the vehicle 3. The embodiment may be combined with the fourth embodiment, and the vehicle 3 may include a plurality of magnetic field detectors 7 and a plurality of transmission-side resonance circuits 43 spaced away from each other along the vehicle width direction of the vehicle 3. Also in this case, the magnetic field detectors 7 and the transmission-side resonance circuits 43 are provided along the direction perpendicular to the traveling direction of the vehicle 3.

## Claims

1. A position estimation method to be applied to a contactless power supply system (1, 1', 1") configured to perform contactless electric power transmission of magnetic field resonance coupling between a ground-side device (2) and a mobile body (3), the contactless power supply system (1) including an alternating current magnetic field generation circuit (6) provided in the ground-side device, a magnetic field detector (7) provided in the mobile body, a transmission-side resonance circuit (43) provided in the mobile body wherein a plurality of the magnetic field detectors (7) is provided along a direction perpendicular to a traveling direction of the mobile body (3), and a reception-side resonance circuit (51) provided in the ground side device, the position estimation method comprising:
generating an alternating current magnetic field by the alternating current magnetic field generation circuit (6);
detecting the alternating current magnetic field by the magnetic field detector (7); and
estimating, based on an output of the magnetic field detectors (7), a relative positional relationship between the transmission-side resonance circuit (43) that transmits electric power and the reception-side resonance circuit (51) that receives the electric power from the transmission-side resonance circuit (43), wherein a frequency of the alternating current magnetic field is different from a resonance frequency of each of the transmission-side resonance circuit (43) and the reception-side resonance circuit (51);
controlling, with a power supply controller (26), the contactless electric power transmission based on the estimated relative positional relationship;
providing a plurality of the transmission-side resonance circuits (43) along the direction perpendicular to the traveling direction of the mobile body (3);
estimating the relative positional relationship based on the transmission-side resonance circuit (43), of the plurality of the transmission-side resonance circuits (43), closest to the reception-side resonance circuit (51) provided in the ground-side device, and
switching, with the power supply controller, the transmission-side resonance circuit (43) that transmits the electric power to the reception-side resonance circuit (51) based on the relative positional relationship in the direction perpendicular to the traveling direction of the mobile body (3).

2. A mobile body (3) configured to receive contactless electric power transmission of magnetic field resonance coupling from a ground-side device (2), the mobile body (3), comprising:
a transmission-side resonance circuit (43) configured to transmit electric power;
a magnetic field detector (7) configured to detect the alternating current magnetic field, wherein a frequency of the alternating current magnetic field is different from a resonance frequency of each of the transmission-side resonance circuit (43) and a reception-side resonance circuit (51), wherein a plurality of the magnetic field detectors (7) is provided along a direction perpendicular to a traveling direction of the mobile body (3); and
a power supply controller (26) configured to control the contactless electric power transmission based on the relative positional relationship estimated by a position estimator (25), wherein:
a plurality of the transmission-side resonance circuits (43) is provided along the direction perpendicular to the traveling direction of the mobile body (3);
the relative positional relationship estimated by the position estimator (25) is based on the transmission-side resonance circuit (43), of the plurality of the transmission-side resonance circuits (43), closest to the reception-side resonance circuit (51) provided in the ground-side device, and
the power supply controller (26) is configured to switch the transmission-side resonance circuit (43) that transmits the electric power to the reception-side resonance circuit (51) based on the relative positional relationship in the direction perpendicular to the traveling direction of the mobile body (3).

3. A ground-side device (2) configured to perform contactless power supply to a mobile body (3), the ground-side device comprising:
a reception-side resonance circuit (51) configured to receive electric power from a transmission-side resonance circuit (43) of the mobile body (3);
an alternating current magnetic field generation circuit (6) configured to generate an alternating current magnetic field for detecting a relative positional relationship between the transmission-side resonance circuit (43) and the reception-side resonance circuit (51);
a control device (22) configured to extract an alternating current magnetic field having a specific frequency from an output of a magnetic field detector (7) of the mobile body, wherein a plurality of the magnetic field detectors (7) is provided along a direction perpendicular to a traveling direction of the mobile body (3), and detect a relative positional relationship between the transmission-side resonance circuit (43) and the reception-side resonance circuit (51) based on the alternating current magnetic field having the specific frequency, wherein the specific frequency is different from a resonance frequency of each of the transmission-side resonance circuit (43) and the reception-side resonance circuit (51); and
a power supply controller (26) configured to control the contactless electric power transmission based on the relative positional relationship, wherein:
a plurality of the transmission-side resonance circuits (43) is provided along the direction perpendicular to the traveling direction of the mobile body (3);
the detected relative positional relationship is based on the transmission-side resonance circuit (43), of the plurality of the transmission-side resonance circuits (43), closest to the reception-side resonance circuit (51) provided in the ground-side device, and
the power supply controller (26) is configured to switch the transmission-side resonance circuit (43) that transmits the electric power to the reception-side resonance circuit (51) based on the relative positional relationship in the direction perpendicular to the traveling direction of the mobile body (3).

4. A contactless power supply system (1, 1', 1") configured to perform contactless electric power transmission of magnetic field resonance coupling between a ground-side device (2) according to claim 3 and a mobile body (3) according to claim 2, the contactless power supply system (1, 1', 1") comprising:
the transmission-side resonance circuit (43) provided in the mobile body and configured to transmit electric power;
the reception-side resonance circuit (51) provided in the ground-side device and configured to receive the electric power from the transmission-side resonance circuit (43);
the alternating current magnetic field generation circuit (6) provided in the ground-side device and configured to generate the alternating current magnetic field for detecting the relative positional relationship between the transmission-side resonance circuit (43) and the reception-side resonance circuit (51);
the magnetic field detector (7) provided in the mobile body and configured to detect the alternating current magnetic field, wherein the frequency of the alternating current magnetic field is different from the resonance frequency of each of the transmission-side resonance circuit (43) and the reception-side resonance circuit (51), wherein the plurality of the magnetic field detectors (7) is provided along the direction perpendicular to the traveling direction of the mobile body (3);
the position estimator (25) configured to estimate the relative positional relationship between the transmission-side resonance circuit (43) and the reception-side resonance circuit (51) based on the output of the magnetic field detectors (7); and
the power supply controller (26) configured to control the contactless electric power transmission based on the relative positional relationship estimated by the position estimator (25), wherein:
the plurality of the transmission-side resonance circuits (43) is provided along the direction perpendicular to the traveling direction of the mobile body (3);
the relative positional relationship estimated by the position estimator (25) is based on the transmission-side resonance circuit (43), of the plurality of the transmission-side resonance circuits (43), closest to the reception-side resonance circuit (51) provided in the ground-side device, and
the power supply controller (26) is configured to switch the transmission-side resonance circuit (43) that transmits the electric power to the reception-side resonance circuit (51) based on the relative positional relationship in the direction perpendicular to the traveling direction of the mobile body (3).

5. The contactless power supply system (1, 1', 1") according to claim 4, wherein the frequency of the alternating current magnetic field is lower than the resonance frequency.

6. The contactless power supply system (1') according to claim 4 or 5, further comprising a filter circuit (8) configured to filter an output of the magnetic field detector (7), wherein the filter circuit (8) is configured to pass a signal having the frequency of the alternating current magnetic field and attenuate a signal having the resonance frequency.

7. The contactless power supply system (1) according to claim 4, further comprising:
a power supply controller (26) configured to control the contactless electric power transmission based on the relative positional relationship estimated by the position estimator (25), wherein the power supply controller (26) is configured to prohibit electric power transmission from the transmission-side resonance circuit (43) to the reception-side resonance circuit (51) based on the position estimator (25) determining that the transmission-side resonance circuit (43) and the reception-side resonance circuit (51) are misaligned in the direction perpendicular to the traveling direction of the mobile body (3).

8. The contactless power supply system (1, 1', 1") according to any one of claims 4 to 7, wherein the alternating current magnetic field includes identification information of the mobile body (3).

## Patentansprüche

1. Positionsschätzverfahren, das auf ein kontaktloses Leistungsversorgungssystem (1, 1', 1") anzuwenden ist, das dazu ausgelegt ist, eine kontaktlose Übertragung elektrischer Leistung einer Magnetfeldresonanzkopplung zwischen einer bodenseitigen Vorrichtung (2) und einem mobilen Körper (3) durchzuführen, wobei das kontaktlose Leistungsversorgungssystem (1) eine Wechselstrommagnetfelderzeugungsschaltung (6), die in der bodenseitigen Vorrichtung bereitgestellt ist, einen Magnetfelddetektor (7), der in dem mobilen Körper bereitgestellt ist, eine übertragungsseitige Resonanzschaltung (43), die in dem mobilen Körper bereitgestellt ist, wobei mehrere der Magnetfelddetektoren (7) entlang einer Richtung senkrecht zu einer Bewegungsrichtung des mobilen Körpers (3) bereitgestellt sind, und eine empfangsseitige Resonanzschaltung (51), die in der bodenseitigen Vorrichtung bereitgestellt ist, umfasst, wobei das Positionsschätzverfahren Folgendes umfasst:
Erzeugen eines Wechselstrommagnetfelds durch die Wechselstrommagnetfelderzeugungsschaltung (6);
Detektieren des Wechselstrommagnetfelds durch den Magnetfelddetektor (7); und
Schätzen, basierend auf einer Ausgabe der Magnetfelddetektoren (7), einer relativen Positionsbeziehung zwischen der übertragungsseitigen Resonanzschaltung (43), die elektrische Leistung überträgt, und der empfangsseitigen Resonanzschaltung (51), die die elektrische Leistung von der übertragungsseitigen Resonanzschaltung (43) empfängt, wobei sich eine Frequenz des Wechselstrommagnetfelds von einer Resonanzfrequenz sowohl der übertragungsseitigen Resonanzschaltung (43) als auch der empfangsseitigen Resonanzschaltung (51) unterscheidet;
Steuern, mit einer Leistungsversorgungssteuerung (26), der kontaktlosen Übertragung elektrischer Leistung basierend auf der geschätzten relativen Positionsbeziehung;
Bereitstellen mehrerer der übertragungsseitigen Resonanzschaltungen (43) entlang der Richtung senkrecht zur Bewegungsrichtung des mobilen Körpers (3);
Schätzen der relativen Positionsbeziehung basierend auf der übertragungsseitigen Resonanzschaltung (43) der mehreren übertragungsseitigen Resonanzschaltungen (43), die sich am nächsten zu der empfangsseitigen Resonanzschaltung (51) befindet, die in der bodenseitigen Vorrichtung bereitgestellt ist, und
Schalten, mit der Leistungsversorgungssteuerung, der übertragungsseitigen Resonanzschaltung (43), die die elektrische Leistung auf die empfangsseitige Resonanzschaltung (51) überträgt, basierend auf der relativen Positionsbeziehung in der Richtung senkrecht zur Bewegungsrichtung des mobilen Körpers (3).

2. Mobiler Körper (3), der dazu ausgelegt ist, eine kontaktlose Übertragung elektrischer Leistung einer Magnetfeldresonanzkopplung von einer bodenseitigen Vorrichtung (2) zu empfangen, wobei der mobile Körper (3) Folgendes umfasst:
eine übertragungsseitige Resonanzschaltung (43), die dazu ausgelegt ist, elektrische Leistung zu übertragen;
einen Magnetfelddetektor (7), der dazu ausgelegt ist, das Wechselstrommagnetfeld zu detektieren, wobei sich eine Frequenz des Wechselstrommagnetfelds von einer Resonanzfrequenz sowohl der übertragungsseitigen Resonanzschaltung (43) als auch einer empfangsseitigen Resonanzschaltung (51) unterscheidet, wobei mehrere der Magnetfelddetektoren (7) entlang einer Richtung senkrecht zu einer Bewegungsrichtung des mobilen Körpers (3) bereitgestellt sind; und
eine Leistungsversorgungssteuerung (26), die dazu ausgelegt ist, die kontaktlose Übertragung elektrischer Leistung basierend auf der relativen Positionsbeziehung zu steuern, die durch eine Positionsschätzvorrichtung (25) geschätzt wird, wobei:
mehrere der übertragungsseitigen Resonanzschaltungen (43) entlang der Richtung senkrecht zur Bewegungsrichtung des mobilen Körpers (3) bereitgestellt sind;
die relative Positionsbeziehung, die durch die Positionsschätzvorrichtung (25) geschätzt wird, auf der übertragungsseitigen Resonanzschaltung (43) der mehreren übertragungsseitigen Resonanzschaltungen (43) basiert, die sich am nächsten zu der empfangsseitigen Resonanzschaltung (51) befindet, die in der bodenseitigen Vorrichtung bereitgestellt ist, und
die Leistungsversorgungssteuerung (26) dazu ausgelegt ist, die übertragungsseitige Resonanzschaltung (43), die die elektrische Leistung auf die empfangsseitige Resonanzschaltung (51) überträgt, basierend auf der relativen Positionsbeziehung in der Richtung senkrecht zur Bewegungsrichtung des mobilen Körpers (3) zu schalten.

3. Bodenseitige Vorrichtung (2), die dazu ausgelegt ist, eine kontaktlose Leistungsversorgung eines mobilen Körpers (3) durchzuführen, wobei die bodenseitige Vorrichtung Folgendes umfasst:
eine empfangsseitige Resonanzschaltung (51), die dazu ausgelegt ist, elektrische Leistung von einer übertragungsseitigen Resonanzschaltung (43) des mobilen Körpers (3) zu empfangen;
eine Wechselstrommagnetfelderzeugungsschaltung (6), die dazu ausgelegt ist, ein Wechselstrommagnetfeld zum Detektieren einer relativen Positionsbeziehung zwischen der übertragungsseitigen Resonanzschaltung (43) und der empfangsseitigen Resonanzschaltung (51) zu erzeugen;
eine Steuervorrichtung (22), die dazu ausgelegt ist, ein Wechselstrommagnetfeld, das eine spezifische Frequenz aufweist, aus einer Ausgabe eines Magnetfelddetektors (7) des mobilen Körpers zu extrahieren, wobei mehrere der Magnetfelddetektoren (7) entlang einer Richtung senkrecht zu einer Bewegungsrichtung des mobilen Körpers (3) bereitgestellt sind, und eine relative Positionsbeziehung zwischen der übertragungsseitigen Resonanzschaltung (43) und der empfangsseitigen Resonanzschaltung (51) basierend auf dem Wechselstrommagnetfeld, das die spezifische Frequenz aufweist, zu detektieren, wobei sich die spezifische Frequenz von einer Resonanzfrequenz sowohl der übertragungsseitigen Resonanzschaltung (43) als auch der empfangsseitigen Resonanzschaltung (51) unterscheidet; und
eine Leistungsversorgungssteuerung (26), die dazu ausgelegt ist, die kontaktlose Übertragung elektrischer Leistung basierend auf der relativen Positionsbeziehung zu steuern, wobei:
mehrere der übertragungsseitigen Resonanzschaltungen (43) entlang der Richtung senkrecht zur Bewegungsrichtung des mobilen Körpers (3) bereitgestellt sind;
die detektierte relative Positionsbeziehung auf der übertragungsseitigen Resonanzschaltung (43) der mehreren übertragungsseitigen Resonanzschaltungen (43) basiert, die sich am nächsten zu der empfangsseitigen Resonanzschaltung (51) befindet, die in der bodenseitigen Vorrichtung bereitgestellt ist, und
die Leistungsversorgungssteuerung (26) dazu ausgelegt ist, die übertragungsseitige Resonanzschaltung (43), die die elektrische Leistung auf die empfangsseitige Resonanzschaltung (51) überträgt, basierend auf der relativen Positionsbeziehung in der Richtung senkrecht zur Bewegungsrichtung des mobilen Körpers (3) zu schalten.

4. Kontaktloses Leistungsversorgungssystem (1, 1', 1"), das dazu ausgelegt ist, eine kontaktlose Übertragung elektrischer Leistung einer Magnetfeldresonanzkopplung zwischen einer bodenseitigen Vorrichtung (2) nach Anspruch 3 und einem mobilen Körper (3) nach Anspruch 2 durchzuführen, wobei das kontaktlose Leistungsversorgungssystem (1, 1', 1") Folgendes umfasst:
die übertragungsseitige Resonanzschaltung (43), die in dem mobilen Körper bereitgestellt und dazu ausgelegt ist, elektrische Leistung zu übertragen;
die empfangsseitige Resonanzschaltung (51), die in der bodenseitigen Vorrichtung bereitgestellt und dazu ausgelegt ist, die elektrische Leistung von der übertragungsseitigen Resonanzschaltung (43) zu empfangen;
die Wechselstrommagnetfelderzeugungsschaltung (6), die in der bodenseitigen Vorrichtung bereitgestellt und dazu ausgelegt ist, das Wechselstrommagnetfeld zum Detektieren der relativen Positionsbeziehung zwischen der übertragungsseitigen Resonanzschaltung (43) und der empfangsseitigen Resonanzschaltung (51) zu erzeugen;
den Magnetfelddetektor (7), der in dem mobilen Körper bereitgestellt und dazu ausgelegt ist, das Wechselstrommagnetfeld zu detektieren, wobei sich die Frequenz des Wechselstrommagnetfelds von der Resonanzfrequenz sowohl der übertragungsseitigen Resonanzschaltung (43) als auch der empfangsseitigen Resonanzschaltung (51) unterscheidet, wobei die mehreren Magnetfelddetektoren (7) entlang der Richtung senkrecht zur Bewegungsrichtung des mobilen Körpers (3) bereitgestellt sind;
die Positionsschätzvorrichtung (25), die dazu ausgelegt ist, die relative Positionsbeziehung zwischen der übertragungsseitigen Resonanzschaltung (43) und der empfangsseitigen Resonanzschaltung (51) basierend auf der Ausgabe der Magnetfelddetektoren (7) zu schätzen; und
die Leistungsversorgungssteuerung (26), die dazu ausgelegt ist, die kontaktlose Übertragung elektrischer Leistung basierend auf der durch die Positionsschätzvorrichtung (25) geschätzten relativen Positionsbeziehung zu steuern, wobei:
die mehreren übertragungsseitigen Resonanzschaltungen (43) entlang der Richtung senkrecht zur Bewegungsrichtung des mobilen Körpers (3) bereitgestellt sind;
die relative Positionsbeziehung, die durch die Positionsschätzvorrichtung (25) geschätzt wird, auf der übertragungsseitigen Resonanzschaltung (43) der mehreren übertragungsseitigen Resonanzschaltungen (43) basiert, die sich am nächsten zu der empfangsseitigen Resonanzschaltung (51) befindet, die in der bodenseitigen Vorrichtung bereitgestellt ist, und
die Leistungsversorgungssteuerung (26) dazu ausgelegt ist, die übertragungsseitige Resonanzschaltung (43), die die elektrische Leistung auf die empfangsseitige Resonanzschaltung (51) überträgt, basierend auf der relativen Positionsbeziehung in der Richtung senkrecht zur Bewegungsrichtung des mobilen Körpers (3) zu schalten.

5. Kontaktloses Leistungsversorgungssystem (1, 1', 1") nach Anspruch 4, wobei die Frequenz des Wechselstrommagnetfelds niedriger als die Resonanzfrequenz ist.

6. Kontaktloses Leistungsversorgungssystem (1') nach Anspruch 4 oder 5, ferner umfassend eine Filterschaltung (8), die dazu ausgelegt ist, einen Ausgang des Magnetfelddetektors (7) zu filtern, wobei die Filterschaltung (8) dazu ausgelegt ist, ein Signal durchzulassen, das die Frequenz des Wechselstrommagnetfelds aufweist, und ein Signal abzuschwächen, das die Resonanzfrequenz aufweist.

7. Kontaktloses Leistungsversorgungssystem (1) nach Anspruch 4, das ferner Folgendes umfasst:
eine Leistungsversorgungssteuerung (26), die dazu ausgelegt ist, die kontaktlose Übertragung elektrischer Leistung basierend auf der durch die Positionsschätzvorrichtung (25) geschätzten relativen Positionsbeziehung zu steuern, wobei die Leistungsversorgungssteuerung (26) dazu ausgelegt ist, eine Übertragung elektrischer Leistung von der übertragungsseitigen Resonanzschaltung (43) auf die empfangsseitige Resonanzschaltung (51) basierend darauf zu unterbinden, dass die Positionsschätzvorrichtung (25) bestimmt, dass die übertragungsseitige Resonanzschaltung (43) und die empfangsseitige Resonanzschaltung (51) in der Richtung senkrecht zur Bewegungsrichtung des mobilen Körpers (3) falsch ausgerichtet sind.

8. Kontaktloses Leistungsversorgungssystem (1, 1', 1") nach einem der Ansprüche 4 bis 7, wobei das Wechselstrommagnetfeld Identifikationsinformationen des mobilen Körpers (3) umfasst.

## Revendications

1. Procédé d'estimation de position destiné à être appliqué à un système d'alimentation électrique sans contact (1, 1', 1") configuré pour réaliser une transmission d'énergie électrique sans contact, de couplage par résonance de champ magnétique, entre un dispositif côté sol (2) et un corps mobile (3), le système d'alimentation électrique sans contact (1) incluant un circuit de génération de champ magnétique à courant alternatif (6) prévu dans le dispositif côté sol, un détecteur de champ magnétique (7) prévu dans le corps mobile, un circuit de résonance côté transmission (43) prévu dans le corps mobile dans lequel une pluralité des détecteurs de champ magnétique (7) est prévue le long d'une direction perpendiculaire à une direction de déplacement du corps mobile (3), et un circuit de résonance côté réception (51) prévu dans le dispositif côté sol, le procédé d'estimation de position comprenant :
la génération d'un champ magnétique à courant alternatif par le circuit de génération de champ magnétique à courant alternatif (6) ;
la détection du champ magnétique à courant alternatif par le détecteur de champ magnétique (7) ; et
l'estimation, sur la base d'une sortie des détecteurs de champ magnétique (7), d'une relation positionnelle relative entre le circuit de résonance côté transmission (43) qui transmet de l'énergie électrique et le circuit de résonance côté réception (51) qui reçoit l'énergie électrique en provenance du circuit de résonance côté transmission (43), dans lequel une fréquence du champ magnétique à courant alternatif est différente d'une fréquence de résonance de chacun du circuit de résonance côté transmission (43) et du circuit de résonance côté réception (51) ;
la commande, avec une unité de commande d'alimentation électrique (26), de la transmission d'énergie électrique sans contact, sur la base de la relation positionnelle relative estimée ;
la fourniture d'une pluralité des circuits de résonance côté transmission (43) le long de la direction perpendiculaire à la direction de déplacement du corps mobile (3) ;
l'estimation de la relation positionnelle relative, sur la base du circuit de résonance côté transmission (43), de la pluralité des circuits de résonance côté transmission (43), le plus près du circuit de résonance côté réception (51) prévu dans le dispositif côté sol, et
la commutation, avec l'unité de commande d'alimentation électrique, du circuit de résonance côté transmission (43) qui transmet l'énergie électrique au circuit de résonance côté réception (51), sur la base de la relation positionnelle relative dans la direction perpendiculaire à la direction de déplacement du corps mobile (3).

2. Corps mobile (3) configuré pour recevoir une transmission d'énergie électrique sans contact, de couplage par résonance de champ magnétique, en provenance d'un dispositif côté sol (2), le corps mobile (3), comprenant :
un circuit de résonance côté transmission (43) configuré pour transmettre de l'énergie électrique ;
un détecteur de champ magnétique (7) configuré pour détecter le champ magnétique à courant alternatif, dans lequel une fréquence du champ magnétique à courant alternatif est différente **d'une** fréquence de résonance de chacun du circuit de résonance côté transmission (43) et d'un circuit de résonance côté réception (51), dans lequel une pluralité des détecteurs de champ magnétique (7) est prévue le long d'une direction perpendiculaire à une direction de déplacement du corps mobile (3) ; et
une unité de commande d'alimentation électrique (26) configurée pour commander la transmission d'énergie électrique sans contact, sur la base de la relation positionnelle relative estimée par un estimateur de position (25), dans lequel :
une pluralité des circuits de résonance côté transmission (43) est prévue le long de la direction perpendiculaire à la direction de déplacement du corps mobile (3) ;
la relation positionnelle relative estimée par l'estimateur de position (25) est basée sur le circuit de résonance côté transmission (43), de la pluralité des circuits de résonance côté transmission (43), le plus près du circuit de résonance côté réception (51) prévu dans le dispositif côté sol, et
l'unité de commande **d'alimentation** électrique (26) est configurée pour commuter le circuit de résonance côté transmission (43) qui transmet l'énergie électrique au circuit de résonance côté réception (51), sur la base de la relation positionnelle relative dans la direction perpendiculaire à la direction de déplacement du corps mobile (3).

3. Dispositif côté sol (2) configuré pour réaliser une alimentation électrique sans contact à un corps mobile (3), le dispositif côté sol comprenant :
un circuit de résonance côté réception (51) configuré pour recevoir de l'énergie électrique en provenance d'un circuit de résonance côté transmission (43) du corps mobile (3) ;
un circuit de génération de champ magnétique à courant alternatif (6) configuré pour générer un champ magnétique à courant alternatif pour détecter une relation positionnelle relative entre le circuit de résonance côté transmission (43) et le circuit de résonance côté réception (51) ;
un dispositif de commande (22) configuré pour extraire un champ magnétique à courant alternatif, ayant une fréquence spécifique, d'une sortie d'un détecteur de champ magnétique (7) du corps mobile, dans lequel une pluralité des détecteurs de champ magnétique (7) est prévue le long d'une direction perpendiculaire à une direction de déplacement du corps mobile (3), et détecter une relation positionnelle relative entre le circuit de résonance côté transmission (43) et le circuit de résonance côté réception (51), sur la base du champ magnétique à courant alternatif ayant la fréquence spécifique, dans lequel la fréquence spécifique est différente d'une fréquence de résonance de chacun du circuit de résonance côté transmission (43) et du circuit de résonance côté réception (51) ; et
une unité de commande d'alimentation électrique (26) configurée pour commander la transmission d'énergie électrique sans contact, sur la base de la relation positionnelle relative, dans lequel :
une pluralité des circuits de résonance côté transmission (43) est prévue le long de la direction perpendiculaire à la direction de déplacement du corps mobile (3) ;
la relation positionnelle relative détectée est basée sur le circuit de résonance côté transmission (43), de la pluralité des circuits de résonance côté transmission (43), le plus près du circuit de résonance côté réception (51) prévu dans le dispositif côté sol, et
l'unité de commande d'alimentation électrique (26) est configurée pour commuter le circuit de résonance côté transmission (43) qui transmet l'énergie électrique au circuit de résonance côté réception (51), sur la base de la relation positionnelle relative dans la direction perpendiculaire à la direction de déplacement du corps mobile (3).

4. Système d'alimentation électrique sans contact (1, 1', 1") configuré pour réaliser une transmission d'énergie électrique sans contact, de couplage par résonance de champ magnétique, entre un dispositif côté sol (2) selon la revendication 3 et un corps mobile (3) selon la revendication 2, le système d'alimentation électrique sans contact (1, 1', 1") comprenant :
le circuit de résonance côté transmission (43) prévu dans le corps mobile et configuré pour transmettre de l'énergie électrique ;
le circuit de résonance côté réception (51) prévu dans le dispositif côté sol et configuré pour recevoir l'énergie électrique en provenance du circuit de résonance côté transmission (43) ;
le circuit de génération de champ magnétique à courant alternatif (6) prévu dans le dispositif côté sol et configuré pour générer le champ magnétique à courant alternatif pour détecter la relation positionnelle relative entre le circuit de résonance côté transmission (43) et le circuit de résonance côté réception (51) ;
le détecteur de champ magnétique (7) prévu dans le corps mobile et configuré pour détecter le champ magnétique à courant alternatif, dans lequel la fréquence du champ magnétique à courant alternatif est différente de la fréquence de résonance de chacun du circuit de résonance côté transmission (43) et du circuit de résonance côté réception (51), dans lequel la pluralité des détecteurs de champ magnétique (7) est prévue le long de la direction perpendiculaire à la direction de déplacement du corps mobile (3) ;
l'estimateur de position (25) configuré pour estimer la relation positionnelle relative entre le circuit de résonance côté transmission (43) et le circuit de résonance côté réception (51), sur la base de la sortie des détecteurs de champ magnétique (7) ; et
l'unité de commande d'alimentation électrique (26) configurée pour commander la transmission d'énergie électrique sans contact, sur la base de la relation positionnelle relative estimée par l'estimateur de position (25), dans lequel :
la pluralité des circuits de résonance côté transmission (43) est prévue le long de la direction perpendiculaire à la direction de déplacement du corps mobile (3) ;
la relation positionnelle relative estimée par l'estimateur de position (25) est basée sur le circuit de résonance côté transmission (43), de la pluralité des circuits de résonance côté transmission (43), le plus près du circuit de résonance côté réception (51) prévu dans le dispositif côté sol, et
l'unité de commande d'alimentation électrique (26) est configurée pour commuter le circuit de résonance côté transmission (43) qui transmet l'énergie électrique au circuit de résonance côté réception (51), sur la base de la relation positionnelle relative dans la direction perpendiculaire à la direction de déplacement du corps mobile (3).

5. Système d'alimentation électrique sans contact (1, 1', 1") selon la revendication 4, dans lequel la fréquence du champ magnétique à courant alternatif est inférieure à la fréquence de résonance.

6. Système d'alimentation électrique sans contact (1') selon la revendication 4 ou 5, comprenant en outre un filtre circuit (8) configuré pour filtrer une sortie du détecteur de champ magnétique (7), dans lequel le filtre circuit (8) est configuré pour faire passer un signal ayant la fréquence du champ magnétique à courant alternatif et atténuer un signal ayant la fréquence de résonance.

7. Système d'alimentation électrique sans contact (1) selon la revendication 4, comprenant en outre :
une unité de commande d'alimentation électrique (26) configurée pour commander la transmission d'énergie électrique sans contact, sur la base de la relation positionnelle relative estimée par l'estimateur de position (25), dans lequel l'unité de commande d'alimentation électrique (26) est configurée pour empêcher la transmission d'énergie électrique depuis le circuit de résonance côté transmission (43) au circuit de résonance côté réception (51), sur la base de la détermination, par l'estimateur de position (25), que le circuit de résonance côté transmission (43) et le circuit de résonance côté réception (51) sont désalignés dans la direction perpendiculaire à la direction de déplacement du corps mobile (3).

8. Système d'alimentation électrique sans contact (1, 1', 1") selon l'une quelconque des revendications 4 à 7, dans lequel le champ magnétique à courant alternatif inclut des informations d'identification du corps mobile (3).
